(19) **Europäisches Patentamt / European Patent Office / Office européen des brevets**

(11) **EP 3 918 430 B1**

(12) **FASCICULE DE BREVET EUROPEEN**

(45) Date de publication et mention
de la délivrance du brevet:
**23.08.2023 Bulletin 2023/34**

(21) Numéro de dépôt: **20701209.7**

(22) Date de dépôt: **27.01.2020**

(51) Classification Internationale des Brevets (IPC):
**G05B 19/042** (2006.01)   **F23N 5/00** (2006.01)
**G05B 11/42** (2006.01)   **F17D 5/02** (2006.01)
**G01M 3/02** (2006.01)   **G01N 27/407** (2006.01)
**G01N 33/00** (2006.01)

(52) Classification Coopérative des Brevets (CPC):
**G01M 3/20; G05B 19/0423**

(86) Numéro de dépôt international:
**PCT/EP2020/051865**

(87) Numéro de publication internationale:
**WO 2020/156973 (06.08.2020 Gazette 2020/32)**

(54) **SYSTEME DE DETECTION DE FUITE PAR GAZ TRACEUR ET UTILISATION CORRESPONDANTE**

SPURENGASLECKERKENNUNGSSYSTEM UND ENTSPRECHENDE VERWENDUNG

TRACER GAS LEAK DETECTION SYSTEM AND CORRESPONDING USE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **29.01.2019 FR 1900806**

(43) Date de publication de la demande:
**08.12.2021 Bulletin 2021/49**

(73) Titulaire: **ATEQ**
**78340 Les Clayes-sous-Bois (FR)**

(72) Inventeur: **MAY, Thierry**
**78340 Les Clayes-sous-Bois (FR)**

(74) Mandataire: **Vidon Brevets & Stratégie**
**16B, rue de Jouanet**
**BP 90333**
**35703 Rennes Cedex 7 (FR)**

(56) Documents cités:
**EP-A1- 1 214 635    EP-A1- 1 467 200**
**EP-A1- 2 270 458    FR-A1- 2 734 053**

Remarques:
Le dossier contient des informations techniques
présentées postérieurement au dépôt de la demande
et ne figurant pas dans le présent fascicule.

**Description**

**Domaine de l'invention**

Le domaine de l'invention est celui de la détection de fuite de gaz traceur, e.g. du type hydrogène, hélium, dioxyde de carbone, diazote, etc.

Plus précisément, l'invention concerne un système de détection de fuite par gaz traceur.

L'invention a de nombreuses applications, notamment, mais non exclusivement, dans le domaine de la sécurité (e.g. pour prévenir le risque d'asphyxie, le risque toxique lié à certains gaz, le risque d'incendie ou d'explosion, etc.), dans le domaine de l'hygiène et de la santé (e.g. pour déterminer des profils d'exposition, aider à la validation de systèmes de captage ou d'assainissement d'air, etc.), etc.

**Art antérieur et ses inconvénients**

On connaît les dispositifs de test d'étanchéité et de détection de fuite par gaz traceur (e.g. du type hydrogène, hélium, dioxyde de carbone, diazote, etc.), dans lesquels l'existence d'une fuite est révélée par un appareil de détection de la présence ou du niveau de gaz traceur dans une chambre de test.

On connaît par exemple les documents FR2734053 ou EP1467200 qui décrivent des dispositifs de test d'étanchéité et de détection de fuite. Dans un certain nombre d'applications le gaz traceur est l'hydrogène et l'appareil de détection est un capteur d'hydrogène. L'utilisation de capteurs d'hydrogène permet ainsi de détecter et/ou mesurer, la présence de ce gaz en temps réel.

Ces capteurs sont bien connus mais présentent un certain nombre d'inconvénients que l'on retrouve quelle que soit la technologie de capteur considérée (e.g. du type électrochimique ou à semi-conducteur).

Tout d'abord ces capteurs d'hydrogène présentent un temps de réponse (ou constante de temps ou temps de montée) relativement élevé dû, notamment, à un effet capacitif ainsi qu'à la résistance de transfert de charge de ce type de capteur. Par exemple, dans le cas des capteurs utilisant une technologie à semi-conducteur, la résistivité du matériau semi-conducteur varie suivant le déroulement de réactions d'oxydo-réduction et/ou d'adsorption à la surface du matériau. Selon un guide des capteurs de gaz de l'INRS (ED 6088 Aide-mémoire technique, février 2011), il est connu que le temps de réponse de ces appareils est très variable, de quelques dizaines de secondes à plusieurs minutes, et que la durée de vie des capteurs est de l'ordre de quelques semaines à plusieurs années en fonction du contexte d'utilisation. En comparant le temps de réponse de différents capteurs d'hydrogène (six capteurs, en l'occurrence), une grande variabilité de leur temps de réponse a été observée. En effet, il a été mesuré des temps de réponse compris entre 15 et 30 secondes.

Par ailleurs, un tel temps de réponse s'avère très élevé par rapport aux attentes/contraintes des applications dans lesquelles sont mis en oeuvre ces capteurs.

Ainsi, il existe un besoin pour réduire le temps de réponse des capteurs de gaz traceurs.

Il existe également un besoin pour qu'une telle réduction n'affecte pas sensiblement la précision de mesure des capteurs en question.

**Exposé de l'invention**

Dans un mode de réalisation, il est proposé un système de détection de fuite par gaz traceur selon la revendication indépendante 1.

Ainsi, l'invention propose une solution nouvelle et inventive pour détecter les fuites de manière améliorée. En effet, de tels capteurs (e.g. du type électrochimiques ou à semi-conducteurs) sensibles à la concentration en gaz traceur (e.g. en hydrogène, hélium, dioxyde de carbone, diazote, etc.) présentent une résistance interne qui varie en suivant une loi logarithmique lorsque la concentration en gaz augmente. Ainsi, lors d'une fuite, le signal délivré par le capteur (e.g. une tension développée sur une résistance de charge) varie de manière exponentielle, ou du moins sensiblement exponentielle, lors de l'arrivée du gaz traceur au niveau du capteur. Un dispositif de correction par avance de phase permettant d'améliorer le temps de montée d'un tel signal exponentiel ou sensiblement exponentiel, le temps de réponse du système de détection se trouve par là-même amélioré.

Selon un mode de réalisation, le dispositif de correction comprend au moins une cellule de correction sur-amortie configurée pour approximer une correction du type proportionnelle-dérivée.

Un facteur d'amortissement de ladite au moins une cellule de correction sur-amortie a une valeur comprise entre 80 et 100 pourcents d'une première valeur critique correspondant au régime critique de ladite au moins une cellule de correction sur-amortie, de préférence une valeur égale à 90 pourcents de la première valeur critique.

Ainsi, le temps de réponse du système de détection se trouve être réduit au mieux par rapport à la constante de temps (ou temps de réponse ou temps de montée) du capteur. Par exemple, la valeur finale du signal délivré par le capteur est atteinte en sortie de la (ou les) cellule de correction sur-amortie après un temps compris entre 0.002*τ et 0.008*τ, avec τ la constante de temps du capteur.

Le facteur d'amortissement de ladite au moins une cellule de correction sur-amortie correspond au ratio entre une constante de temps associée au zéro dominant d'une fonction de transfert de ladite au moins une cellule de correction sur-amortie et une constante de temps du capteur.

Selon le mode de réalisation, le dispositif de correction comprend au moins une cellule de correction sous-amortie configurée pour approximer une correction du type proportionnelle-dérivée.

Un facteur d'amortissement de ladite au moins une cellule de correction sous-amortie a une valeur comprise entre 110 et 130 pourcents d'une deuxième valeur critique correspondant au régime critique de ladite au moins une cellule de correction sous-amortie, de préférence une valeur égale à 120 pourcents de la deuxième valeur critique.

Ainsi, la valeur finale atteinte par le signal corrigé délivré par la (ou les) cellule sous-amortie est cohérente (i.e. est sensiblement égale), à la valeur finale du signal délivré par le capteur. Par exemple, lorsque le facteur d'amortissement de la (ou des) cellule de correction sur-amortie est choisi égal à 90 pourcents de la valeur correspondant à son régime critique, et lorsque le facteur d'amortissement de la (ou des) cellule de correction sous-amortie est choisi égal à 120 pourcents de la valeur correspondant à son régime critique, un gain sensiblement unitaire est obtenu pour le système de détection composé des cellules sur-amortie(s) et sous-amortie(s) en question lorsque le signal corrigé est observé après un temps d'établissement de l'ordre de 0.005*τ.

Le facteur d'amortissement de ladite au moins une cellule de correction sous-amortie correspond au ratio entre une constante de temps associée au zéro dominant d'une fonction de transfert de ladite au moins une cellule de correction sous-amortie et la constante de temps du capteur.

Selon le mode de réalisation, ladite au moins une cellule de correction sur-amortie délivre un premier signal corrigé à partir du signal capteur, et ladite au moins une cellule de correction sous-amortie délivre le signal corrigé à partir du premier signal corrigé.

Ladite au moins une cellule de correction sur-amortie et/ou ladite au moins une cellule de correction sous-amortie est implémentée sous une forme analogique active.

Par exemple, les cellules sur-amortie(s) et sous-amortie(s) en question sont implémentées sous forme de montages à base d'amplificateurs opérationnels rebouclés. De la sorte, les problématiques d'adaptation d'impédance, ou de dispersion des composants utilisés (capacités, résistances), sont minimisées au sein du dispositif de correction par avance de phase. Ceci permet par exemple d'éviter les oscillations avant stabilisation du signal corrigé.

Dans un autre mode de réalisation de l'invention, il est proposé une utilisation d'un système de détection de fuite par gaz traceur selon l'un quelconque des modes de réalisation précités pour détecter une fuite par gaz traceur.

## Liste des figures

D'autres buts, caractéristiques et avantages de l'invention apparaîtront plus clairement à la lecture de la description suivante, donnée à titre de simple exemple illustratif, et non limitatif, en relation avec les figures, parmi lesquelles :

[Fig 1] représente un schéma électrique équivalent du capteur semi-conducteur de détection de gaz SB-19 de la société FIS® ;

[Fig 2] représente l'évolution de la résistance interne du schéma électrique équivalent de la [Fig 1] en fonction de la concentration en gaz au niveau du capteur SB-19 ;

[Fig 3] représente un système de détection de fuite par gaz traceur selon un mode de réalisation de l'invention.

## Description détaillée de modes de réalisation de l'invention

Sur toutes les figures du présent document, les éléments et étapes identiques sont désignés par une même référence.

Le principe général de l'invention repose sur la mise en oeuvre d'un dispositif de correction par avance de phase afin d'améliorer le temps de réponse (ou constante de temps ou temps de montée) d'un capteur (e.g. du type électrochimique ou à semi-conducteur) de gaz traceur (e.g. du type hydrogène, hélium, dioxyde de carbone, diazote, etc.).

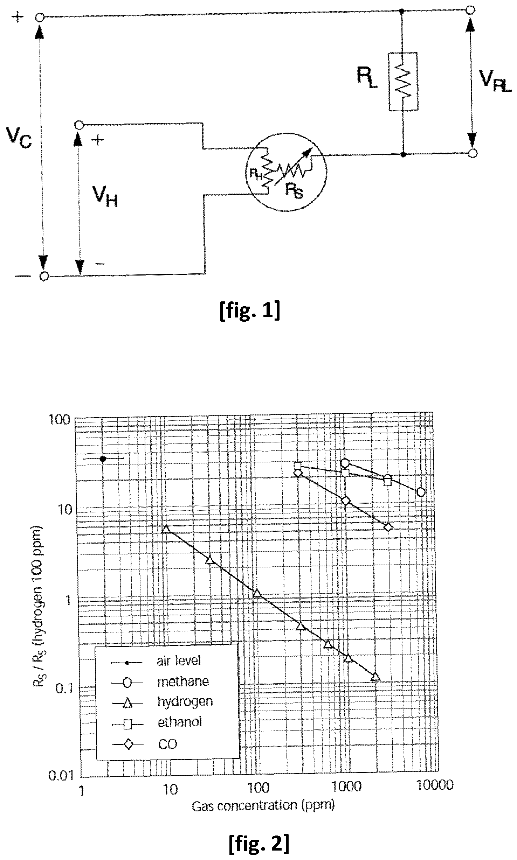

On présente désormais en relation avec les **[Fig 1]** et **[Fig 2]** les caractéristiques du schéma électrique équivalent du capteur semi-conducteur de détection de gaz SB-19 de la société FIS®.

En effet, le capteur de gaz SB-19 est un capteur semi-conducteur typique auquel peut s'appliquer l'invention. Le capteur en question est du type à dioxyde d'étain, ce qui permet une faible consommation d'énergie (120mW), le rendant ainsi particulièrement adapté à une intégration dans un système portatif de détection de gaz.

Le capteur présente un boîtier métallique comprenant une paroi formée d'un double maillage en acier inoxydable et située dans le trajet du flux de gaz. Le boîtier renferme un élément de détection en forme de goutte (ou de perle) comprenant une bobine chauffante et une électrode. Le capteur SB-19 présente également un temps de réponse particulièrement long, i.e. de l'ordre de 15 à 30s.

Comme le montre le schéma électrique équivalent du capteur SB-19 illustré sur la [Fig 1], ainsi que l'évolution de la résistance interne du schéma électrique en question illustrée sur la [Fig 2] en fonction de la concentration en gaz au niveau du capteur SB-19, le capteur en question se comporte comme une source de tension dont la résistance interne $R_S$ est variable en fonction de la concentration en gaz au niveau du capteur. Le capteur développe ainsi une tension $V_{RL}$, variable et fonction de la concentration en gaz au niveau du capteur, aux bornes d'une résistance de charge RL.

Les caractéristiques de sensibilité d'un tel capteur sont exprimées par la relation entre la résistance interne $R_S$ et la concentration du gaz au niveau du capteur en question.

Plus particulièrement, ce type de capteur est annoncé comme permettant de détecter des teneurs en hydrogène comprises entre 100ppm et 1000ppm. La résistance interne du capteur $R_S$ diminue avec l'augmentation de la concentration de gaz en suivant une loi logarithmique comme illustré sur [Fig 2]. De la sorte, pour une résistance de charge $R_L$ donnée, la tension développée $V_{RL}$ varie de manière exponentielle, ou du moins sensiblement exponentielle, lors de l'arrivée du gaz au niveau du capteur. En d'autres termes, le capteur répond comme un système linéaire du premier ordre, e.g. comme un filtre RC (pour « résistance-capacité ») monté en passe-bas et dont la capacité se chargerait à l'arrivée du gaz au contact du capteur jusqu'à atteindre une valeur représentative de la concentration en gaz au niveau du capteur.

Le même type de comportement est obtenu avec différentes technologies de capteurs (e.g. du type électrochimique ou à semi-conducteur), et pour des capteurs sensibles à différents types de gaz traceurs (e.g. du type hydrogène, hélium, dioxyde de carbone, diazote, etc.).

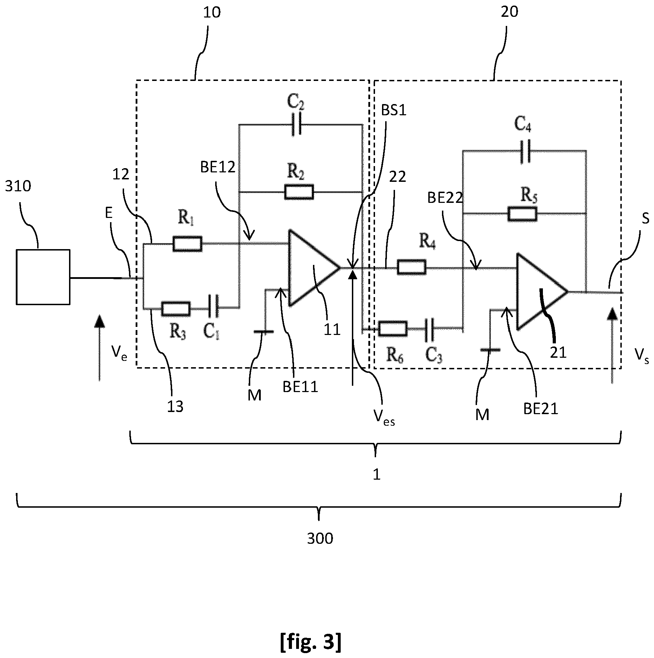

On présente désormais en relation avec la **[Fig 3]** un système 300 de détection de fuite par gaz traceur selon un mode de réalisation de l'invention.

Le système 300 comprend un capteur 310 de gaz traceur. Dans le mode de réalisation illustré, le capteur 310 est le capteur SB-19 dont les caractéristiques ont été discutées ci-dessus en relation avec les [Fig 1] et [Fig 2]. Dans ce mode de réalisation, le gaz traceur est l'hydrogène. Dans d'autres modes de réalisation non illustrés, le gaz considéré est un autre gaz traceur quelconque (e.g. du type hélium, dioxyde de carbone, diazote, etc.), et le capteur est un capteur adapté correspondant (e.g. du type électrochimique ou à semi-conducteur).

De retour à la [Fig 3], le système 300 comprend en outre un dispositif 1 de correction délivrant un signal corrigé Vs à partir du signal de mesure Ve délivré par le capteur 310. Dans le mode de réalisation considéré, le dispositif 1 de correction est dimensionné pour être du type haute impédance et les signaux en question sont représentés par des tensions aux bornes de résistances de charge. Dans d'autres modes de réalisation, le dispositif 1 de correction est dimensionné pour être du type basse impédance et les signaux de mesure sont du type courant traversant une résistance de charge.

Dans le mode de réalisation illustré, le système de détection de fuite comprend un seul capteur. Dans d'autres modes de réalisation, le système de détection de fuite comprend plusieurs capteurs, potentiellement dédiés à la mesure de différent gaz traceurs. Dans de tels modes de réalisation, le système de détection de fuite comprend au moins un dispositif de correction délivrant un signal corrigé à partir du signal de mesure délivré par un capteur donné du système de détection de fuite.

De retour à la [Fig 3], le dispositif 1 de correction est un dispositif de correction par avance de phase. En effet, comme décrit ci-dessus en relation avec les [Fig 1] et [Fig 2], le capteur 310 développe une tension qui varie de manière exponentielle, ou du moins sensiblement exponentielle, lors de l'arrivée du gaz à son niveau. Or, un dispositif 1 de correction par avance de phase permet, via la fonction de dérivation qu'il implémente, d'améliorer le temps de montée d'un tel signal exponentiel, ou sensiblement exponentiel. De la sorte, le temps de réponse du système 300 de détection se trouve amélioré par rapport au temps de réponse du capteur 310 seul.

Le dispositif 1 de correction par avance de phase comprend une première 10 et une deuxième 20 cellules de correction de structure électronique identique, les première 10 et deuxième 20 cellules étant connectées en série.

Plus particulièrement, chacune des première 10 et deuxième 20 cellules est un circuit à avance de phase, construit autour d'un amplificateur opérationnel (aussi appelé par la suite « ampli op »), avec une boucle de contre-réaction sur l'entrée inverseuse de ce dernier.

La première cellule 10 comprend un ampli op 11 présentant une entrée non inverseuse BE11, reliée à la masse M, et une entrée inverseuse BE12. L'entrée E du dispositif 1 de correction est connectée à l'entrée inverseuse BE12 de l'ampli op 11 via un bloc comprenant deux branches en parallèle : la première branche 12 comprend une résistance $R_1$ et la deuxième branche 13 comprenant une résistance $R_3$ et un condensateur $C_1$ en série. L'ampli op 11 comprend également une sortie BS1 qui est connectée d'une part à l'entrée de la deuxième cellule 20 du correcteur 1, et d'autre part à l'entrée inverseuse BE12 de l'ampli op 11 via une boucle de contre-réaction comprenant une résistance $R_2$ et un condensateur $C_2$ connectés en parallèle.

La deuxième cellule 20 du dispositif 1 de correction présente une structure électronique analogue à celle de la première cellule 10. Plus précisément, la deuxième cellule 20 présente un ampli op 21 présentant une entrée non inverseuse BE21, reliée à la masse M, et une entrée inverseuse BE22. La sortie BS1 de l'ampli op 11 (c'est-à-dire la sortie de la première cellule 10) est connectée à l'entrée inverseuse BE22 de l'ampli op 21 via un bloc comprenant deux branches en parallèle : une première branche 22 comprend une résistance $R_4$ et une deuxième branche 23 comprend une résistance $R_6$ et un condensateur $C_3$ en série.

L'ampli op 21 comprend également une sortie BS2 qui est connectée d'une part à l'entrée inverseuse BE22 de l'ampli op 21 via une boucle de contre-réaction comprenant une résistance $R_5$ et un condensateur $C_4$ connectés en parallèle, et d'autre part à la sortie S du correcteur 1.

A partir du schéma de la [Fig 3], la fonction de transfert du dispositif 1 de correction peut s'exprimer dans le domaine de Laplace comme :

$$H_{(P)} = H_{0(P)} H_{1(P)} H_{2(P)}$$

avec :

- $H_{0(P)} = \frac{R_2 \times R_5}{R_1 \times R_4}$ le gain à fréquence nulle du dispositif 1 de correction ;

- $H_{1(P)} = \frac{(1 + R_1 C_1 p + R_3 C_1 p)}{(1 + R_2 C_2 p)(1 + R_3 C_1 p)}$ la fonction de transfert comprenant les pôles et les zéros liées à la première cellule 10 ; et

- $H_{2(P)} = \frac{(1 + R_4 C_3 p + R_6 C_3 p)}{(1 + R_5 C_4 p)(1 + R_6 C_3 p)}$ la fonction de transfert comprenant les pôles et les zéros liées à la deuxième cellule 20.

De manière générale, $H_{1(p)}$ et $H_{2(p)}$ peuvent être réécrites sous la forme :

$$H_{1(P)} = \frac{1 + \tau_1 p + \tau_2 p}{(1 + \tau_3 p)(1 + \tau_2 p)}$$

et :

$$H_{2(P)} = \frac{1 + \tau_4 p + \tau_5 p}{(1 + \tau_6 p)(1 + \tau_5 p)}$$

avec :

- $\tau_1 = R_1.C_1 = R_2.C_1$
- $\tau_2 = R_3.C_1$
- $\tau_3 = R_2.C_2 = R_1.C_2$
- $\tau_4 = R_4.C_3 = R_5.C_3$
- $\tau_5 = R_6.C_3$
- $\tau_6 = R_5.C_4 = R_4.C_4$

Chacune des première 10 et deuxième 20 cellules présentent à la fois des pôles et des zéros et s'apparente ainsi de manière générale à une cellule de correction du type PID (pour « Proportionnelle, Intégrale et Dérivée »). Afin d'obtenir des cellules à avance de phase, une réduction des pôles est effectuée pour rendre la fonction de dérivation prédominante.

Pour ce faire, il est par exemple choisi $R_2 = R_1$ et $R_5 = R_4$. De la sorte, $H_{0(P)} = 1$.

De même, les pôles et zéros du dispositif 1 de correction sont configurés pour avoir :

- les zéros associés aux constantes de temps $R_2.C_2$ et $R_3.C_3$ qui soient dominants dans la fonction de transfert $H_{(p)}$ (de tels zéros correspondant à la fonction de dérivation souhaitée) ;
- les pôles associés aux constantes de temps $R_2.C_2$ et $R_5.C_4$, qui soient du 2ème ordre dans la fonction de transfert $H_{(p)}$ (les pôles en question correspondants à la fonction d'intégration ;
- les pôles associés aux constantes de temps $R_3.C_1$ et $R_6.C_3$, qui soient du 3ème ordre dans la fonction de transfert $H_{(p)}$ (les pôles en question correspondants à une fonction de stabilisation du dispositif).

La réduction des pôles peut ainsi être effectuée sur les pôles auxiliaires (i.e. du 2ème ordre et du 3ème ordre) dans la mesure où le temps de réponse envisagé pour les pôles en question est suffisamment supérieur au temps de réponse critique du dispositif 1 de correction (i.e. au temps de réponse défini comme le temps de réponse minimum fournissant une surtension du signal Vs en sortie du dispositif 1 de correction).

Par exemple, en choisissant T2 = T3 et T5 = T6, on obtient :

$$H_{1(P)} = \frac{1 + \tau_1 p + \tau_2 p}{(1 + \tau_2 p)^2}$$

et :

$$H_{2(P)} = \frac{1 + \tau_4 p + \tau_5 p}{(1 + \tau_5 p)^2}$$

En configurant la première cellule 10 de sorte que $\tau 2 \ll \tau 1$, on obtient au premier ordre que :

$$H_{1(P)} \approx 1 + \tau_1 p$$

Dans l'hypothèse discutée ci-dessus où le capteur 310 développe une tension Ve qui varie de manière exponentielle lors de l'arrivée du gaz, on peut écrire la tension Ve en question sous la forme :

$$V_{e(t)} = E\left(1 - e^{-t/\tau}\right)$$

avec $\tau$ la constante de temps (ou temps de réponse ou temps de montée) du capteur 310.

Ainsi, sur la base de l'expression ci-dessus de $H_{1(p)}$, la tension Ves développée en sortie de la première cellule 10 peut s'écrire au premier ordre :

$$V_{es(t)} = E\left[1 - (1 - m)\mathrm{e}^{\frac{-t}{\tau}}\right]$$

avec m le coefficient d'amortissement de la première cellule 10, qui s'exprime donc au premier ordre comme $m = \tau_1/\tau$ (i.e. comme le ratio entre la constante de temps associée au zéro dominant de la fonction de transfert de la première cellule 10 sur-amortie et la constante de temps du capteur).

Ainsi, la première cellule 10 est configurée pour approximer une correction du type proportionnelle-dérivée (e.g. comprenant au moins une fonction de dérivation).

De manière générale, afin d'éviter toute oscillation du signal délivré par la première cellule 10, la cellule en question est dimensionnée pour être sur-amortie, i.e. pour avoir son coefficient d'amortissement *m* inférieur ou égale à une valeur critique correspondant au régime critique de la première cellule 10 (on comprend ici que l'on entend l'expression sur-amortie au sens large, i.e. incluant le régime critique correspondant à un coefficient d'amortissement égal à la valeur critique). Par exemple, le coefficient d'amortissement *m* est configuré pour avoir une valeur comprise entre 80 et 100 pourcents de la valeur critique de la première cellule 10.

Par exemple, le coefficient d'amortissement *m* est configuré pour avoir une valeur égale à 90 pourcents de la valeur critique de la première cellule 10. Ainsi, le temps de réponse du système 1 de détection se trouve être réduit au mieux par rapport à la constante de temps T du capteur 310. Par exemple, la valeur finale du signal Ves délivré par la première cellule 10 est atteinte en sortie de la première cellule 10 sur-amortie après un temps compris entre $0.002*\tau$ et $0.008*\tau$.

Par ailleurs, en configurant la deuxième cellule 20 de sorte que $\tau 5 \ll \tau 4$, on obtient au premier ordre que :

$$H_{2(P)} \approx 1 + \tau_4 p$$

Ainsi, toujours en considérant que $V_{e(t)} = E(1 - e^{-t/\tau})$, la tension Vs développée en sortie de la deuxième cellule 20 peut s'écrire au premier ordre :

$$V_s = E[1 - (1 - km')\mathrm{e}^{\frac{-t}{\tau}}]$$

avec $m'$ le coefficient d'amortissement de la deuxième cellule 20, qui s'exprime donc au premier ordre comme $m' = \tau_4/\tau$ (i.e. comme le ratio entre la constante de temps associée au zéro dominant de la fonction de transfert de la deuxième cellule 20 sous-amortie et la constante de temps du capteur), et $k$ une constante qui simule l'effet de la première cellule 10 sur-amortie sur le signal Ve délivré par le capteur.

Ainsi, la deuxième cellule 20 est configurée pour approximer une correction du type proportionnelle-dérivée (e.g. comprenant au moins une fonction de dérivation).

Cependant, dans le mode de réalisation considéré, la deuxième cellule 20 est configurée pour être sous-amortie afin de compenser le biais obtenu après un temps prédéterminé dans le signal Ves délivré par la première cellule 10 (qui, elle, est sur-amortie) par rapport au signal Ve délivré par le capteur. Ainsi, la valeur finale atteinte par le signal corrigé Vs délivré par la deuxième cellule 20 sous-amortie est cohérente (i.e. est sensiblement égale), à la valeur finale du signal Ve délivré par le capteur lorsque considéré après le temps prédéterminé en question.

Par exemple, la deuxième cellule 20 est dimensionnée pour avoir son coefficient d'amortissement $m'$ supérieur à une valeur critique correspondant au régime critique de la deuxième cellule 20. Par exemple, le coefficient d'amortissement $m'$ est configuré pour avoir une valeur comprise entre 110 et 120 pourcents de la valeur critique de la deuxième cellule 20.

Par exemple, lorsque le facteur d'amortissement m de la première cellule 10 sur-amortie est choisi égal à 90 pourcents de la valeur correspondant à son régime critique, et lorsque le facteur d'amortissement de la deuxième cellule 20 sous-amortie est choisi égal à 120 pourcents de la valeur correspondant à son régime critique, un gain sensiblement unitaire est obtenu pour le système 1 de détection composé des première 10 et deuxième 20 cellules lorsque le signal corrigé Vs est observé après un temps d'établissement de l'ordre de $0.005*\tau$. (e.g. la valeur finale atteinte par le signal corrigé Vs délivré par la deuxième cellule 20 sous-amortie est cohérente (i.e. est sensiblement égale), à la valeur finale du signal Ve délivré par le capteur lorsque le signal corrigé Vs est observé après un temps d'établissement de l'ordre de $0.005*\tau$).

Ceci se comprend en faisant une analogie avec une fonction de transfert générique d'un système du second ordre en réponse indicielle, à savoir dans le domaine de Laplace :

$$H_{(p)} = H_0 \frac{\omega_0^2}{p^2 + 2m'\omega_0 p + \omega_0^2}$$

avec $\omega_0$ la pulsation naturelle du système en question. Pour un tel système, la valeur maximale de dépassement du signal de sortie peut s'exprimer en fonction du facteur d'amortissement $m'$. Plus particulièrement, pour un échelon de tension en entrée, i.e. $E_p = \frac{1}{p}$ dans le domaine de Laplace, on obtient en sortie le signal :

$$S_{(p)} = \frac{1}{p} \frac{\omega_0^2}{p^2 + 2m'\omega_0 + \omega_0^2} = \frac{1}{p} - \frac{p + 2pm'\omega_0}{(p + m'\omega_0)^2 + \omega_0^2(1 - m'^2)}$$

où $\omega_S = \omega_0\sqrt{1 - m'^2}$ représente la pseudo pulsation du signal de sortie dans le régime sous amorti. Par transformée de Laplace inverse, on obtient dans le domaine temporel :

$$S_{(t)} = [1 - \frac{\mathrm{e}^{-m'\omega_0 t}}{\sqrt{1 - m'^2}} \sin(\omega_0 t + \varphi)]E_{(t)}$$

La valeur maximale de dépassement $M_d$ du signal de sortie par rapport à la valeur de l'échelon mis en entrée du système s'exprime comme :

$$M_d = \mathrm{e}^{\frac{-m'\pi}{\sqrt{1-m'^2}}}$$

En se fixant par exemple une valeur maximale de dépassement $M_d$ égale à 1.5% de la valeur de l'échelon (ce qui permet de compenser par exemple l'effet de la première cellule 10 sur-amortie lorsque son facteur d'amortissement $m$ est choisi égal à 90 pourcents de la valeur correspondant à au régime critique de la première cellule 10), on obtient :

$$m' = \sqrt{\frac{\ln^2(M_d)}{\ln^2(M_d) + \pi^2}} = 1.2$$

Un tel système 300 de détection de fuite peut ainsi être utilisé pour détecter une fuite par gaz traceur (ici l'hydrogène) avec un temps de réponse amélioré par rapport à celui du capteur 310 seul.

Dans le mode de réalisation de la [Fig 3], le dispositif 1 de correction par avance de phase comprend une première 10 et une deuxième 20 cellules de correction de structure électronique identique, les première 10 et deuxième 20 cellules étant connectées en série.

Dans certains autres modes de réalisation non illustrés, le dispositif de correction par avance de phase comprend plusieurs cellules de correction du type sur-amortie et/ou plusieurs cellules de correction du type sous-amorties. Par exemple le dispositif de correction par avance de phase comprend plusieurs cellules 10 et 20 telles que décrites ci-dessus, mises en série et configurées pour obtenir la fonction de transfert globale voulue comprenant au moins une fonction de dérivation. Chaque cellule parmi les cellules 10 a par exemple un coefficient d'amortissement configuré pour avoir une valeur comprise entre 80 et 100 pourcents de la valeur critique de la cellule 10 en question. De même, chaque cellule parmi les cellules 20 a par exemple un coefficient d'amortissement configuré pour avoir une valeur comprise entre 110 et 120 pourcents de la valeur critique de la cellule 20 en question.

A contrario, dans certains autres modes de réalisation, le dispositif de correction par avance de phase comprend seulement une cellule de correction par avance de phase (sur-amortie ou sous-amortie) afin de simplifier l'implémentation.

Dans le mode de réalisation de la [Fig 3], les première 10 et deuxième 20 cellules de correction sont implémentées sous une forme analogique active, ici à base d'amplificateurs opérationnels rebouclés. De la sorte, les problématiques d'adaptation d'impédance, ou de dispersion des composants utilisés (capacités, résistances), sont minimisées au sein du dispositif 1 de correction. Ceci permet par exemple d'éviter les oscillations avant stabilisation du signal corrigé.

Dans d'autres modes de réalisation, le dispositif de correction par avance de phase est implémenté de manière passive, par exemple via une cellule passe haut du type capacité série et résistance parallèle.

Dans le mode de réalisation de la [Fig 3], le signal Ve délivré par le capteur est traité par la première cellule 10 sur-amortie et le signal corrigé Vs est délivré par la deuxième cellule 20 sous-amortie.

Dans d'autres modes de réalisation, l'ordre des cellules est inversé, i.e. le signal Ve délivré par le capteur est traité par une cellule sous-amortie et le signal corrigé Vs est délivré par une cellule sur-amortie.

## Revendications

1. Système (300) de détection de fuite par gaz traceur comprenant au moins un capteur (310) délivrant un signal, dit signal capteur, représentatif d'une concentration dudit gaz traceur au niveau dudit capteur,
   **caractérisé en ce que,** pour au moins un capteur donné, ledit système comprend en outre un dispositif (1) de correction par avance de phase correspondant configuré pour délivrer un signal corrigé (Vs) à partir du signal capteur (Ve) délivré par ledit capteur donné, ledit dispositif de correction (1) comprenant, d'une part, au moins une cellule (10) de correction sur-amortie configurée pour approximer une correction du type proportionnelle-dérivée, et, d'autre part, au moins une cellule (20) de correction sous-amortie configurée pour approximer une correction du type proportionnelle-dérivée, lesdites cellule (10) de correction sur-amortie et cellule (20) de correction sous-amortie étant connectées en série.

2. Système selon la revendication 1 dans lequel un facteur d'amortissement de ladite au moins une cellule de correction sur-amortie a une valeur comprise entre 80 et 100 pourcents d'une première valeur critique correspondant au régime critique de ladite au moins une cellule de correction sur-amortie, de préférence une valeur égale à 90 pourcents de ladite première valeur critique.

3. Système selon la revendication 2 dans lequel ledit facteur d'amortissement de ladite au moins une cellule de correction sur-amortie correspond au ratio entre une constante de temps associée au zéro dominant d'une fonction de transfert de ladite au moins une cellule de correction sur-amortie et une constante de temps du capteur.

4. Système selon la revendication 1, dans lequel un facteur d'amortissement de ladite au moins une cellule de correction sous-amortie a une valeur comprise entre 110 et 130 pourcents d'une deuxième valeur critique correspondant au régime critique de ladite au moins une cellule de correction sous-amortie, de préférence une valeur égale à 120 pourcents de ladite deuxième valeur critique.

5.  Système selon la revendication 4 dans lequel ledit facteur d'amortissement de ladite au moins une cellule de correction sous-amortie correspond au ratio entre une constante de temps associée au zéro dominant d'une fonction de transfert de ladite au moins une cellule de correction sous-amortie et ladite constante de temps du capteur.

6.  Système selon l'une quelconque des revendications 1 à 5 dans lequel ladite au moins une cellule (10) de correction sur-amortie délivre un premier signal corrigé (Ves) à partir dudit signal capteur (Ve), et dans lequel ladite au moins une cellule (20) de correction sous-amortie délivre ledit signal corrigé (Vs) à partir dudit premier signal corrigé (Ves).

7.  Système selon l'une quelconque des revendications 1 à 6 dans lequel ladite au moins une cellule de correction sur-amortie et/ou ladite au moins une cellule de correction sous-amortie est implémentée sous une forme analogique active.

8.  Utilisation d'un système (300) selon l'une quelconque des revendications 1 à 7 pour détecter une fuite par gaz traceur.


**Patentansprüche**

1.  System (300) zur Erkennung von Lecks mit Spürgas mit mindestens einem Sensor (310), der ein Signal, Sensorsignal genannt, liefert, das repräsentativ für eine Konzentration des Spürgases an dem Sensor ist,
    **dadurch gekennzeichnet, dass** das System für mindestens einen gegebenen Sensor außerdem eine entsprechende Korrekturvorrichtung (1) durch Phasenvoreilung umfasst, die so konfiguriert ist, dass sie ausgehend von dem Sensorsignal (Ve), das von dem gegebenen Sensor geliefert wird, ein korrigiertes Signal (Vs) abgibt, wobei die Korrekturvorrichtung (1) einerseits mindestens eine Überdämpfungskorrekturzelle (10), die so konfiguriert ist, dass sie eine Korrektur vom Typ proportional-abgeleitet approximiert, und andererseits mindestens eine Unterdämpfungskorrekturzelle (20) umfasst, die so konfiguriert ist, dass sie eine Korrektur vom Typ proportional-abgeleitet approximiert, wobei die Überdämpfungskorrekturzelle (10) und die Unterdämpfungskorrekturzelle (20) in Reihe geschaltet sind.

2.  System nach Anspruch 1, bei dem ein Dämpfungsfaktor der mindestens einen Überdämpfungskorrekturzelle einen Wert zwischen 80 und 100 Prozent eines ersten kritischen Wertes hat, der dem kritischen Zustand der mindestens einen Überdämpfungskorrekturzelle entspricht, vorzugsweise einen Wert von 90 Prozent des ersten kritischen Wertes.

3.  System nach Anspruch 2, wobei der Dämpfungsfaktor der mindestens einen Überdämpfungskorrekturzelle dem Verhältnis zwischen einer Zeitkonstante, die mit der dominanten Nullstelle einer Übertragungsfunktion der mindestens einen Überdämpfungskorrekturzelle verknüpft ist, und einer Zeitkonstante des Sensors entspricht.

4.  System nach Anspruch 1, wobei ein Dämpfungsfaktor der mindestens einen Unterdämpfungskorrekturzelle einen Wert zwischen 110 und 130 Prozent eines zweiten kritischen Werts hat, der dem kritischen Zustand der mindestens einen Unterdämpfungskorrekturzelle entspricht, vorzugsweise einen Wert gleich 120 Prozent des zweiten kritischen Werts.

5.  System nach Anspruch 4, wobei der Dämpfungsfaktor der mindestens einen Unterdämpfungskorrekturzelle dem Verhältnis zwischen einer Zeitkonstante, die mit der dominanten Nullstelle einer Übertragungsfunktion der mindestens einen Unterdämpfungskorrekturzelle verknüpft ist, und der Zeitkonstante des Sensors entspricht.

6.  System nach einem der Ansprüche 1 bis 5, wobei die mindestens eine Überdämpfungskorrekturzelle (10) ein erstes korrigiertes Signal (Ves) ausgehend von dem Sensorsignal (Ve) abgibt, und wobei die mindestens eine Unterdämpfungskorrekturzelle (20) das korrigierte Signal (Vs) ausgehend von dem ersten korrigierten Signal (Ves) abgibt.

7.  System nach einem der Ansprüche 1 bis 6, wobei die mindestens eine Überdämpfungskorrekturzelle und/oder die mindestens eine Unterdämpfungskorrekturzelle in aktiver analoger Form implementiert ist.

8.  Verwendung eines Systems (300) nach einem der Ansprüche 1 bis 7, um ein Leck mit Spürgas zu erkennen.

**Claims**

1. Tracer gas leak detection system (300) comprising at least one sensor (310) delivering a signal, referred to as sensor signal, which is representative of a concentration of said tracer gas at said sensor, **characterised in that,** for at least one given sensor, said system further comprises a corresponding phase advance correction device (1) configured to deliver a corrected signal (Vs) from the sensor signal (Ve) delivered by said given sensor, said correction device (1) comprising, on the one hand, at least one overdamped correction cell (10) configured to approximate a correction of the proportional-derivative type, and, on the other hand, at least one underdamped correction cell (20) configured to approximate a correction of the proportional-derivative type, said overdamped correction cell (10) and underdamped correction cell (20) being connected in series.

2. System according to claim 1 wherein a damping factor of said at least one overdamped correction cell has a value comprised between 80 and 100 percent of a first critical value corresponding to the critical regime of said at least one overdamped correction cell, preferably a value equal to 90 percent of said first critical value.

3. System according to claim 2 wherein said damping factor of said at least one overdamped correction cell corresponds to the ratio between a time constant associated with the dominant zero of a transfer function of said at least one overdamped correction cell and a time constant of the sensor.

4. System according to claim 1 in that it depends on 2 wherein a damping factor of said at least one underdamped correction cell has a value comprised between 110 and 130 percent of a second critical value corresponding to the critical regime of said at least one underdamped correction cell, preferably a value equal to 120 percent of said second critical value.

5. System according to claim 4 wherein said damping factor of said at least one underdamped correction cell corresponds to the ratio between a time constant associated with the dominant zero of a transfer function of said at least one underdamped correction cell and said time constant of the sensor.

6. System according to any of claims 1 to 5 wherein said at least one overdamped correction cell (10) delivers a first corrected signal (Ves) from said sensor signal (Ve), and wherein said at least one underdamped correction cell (20) delivers said corrected signal (Vs) from said first corrected signal (Ves).

7. System according to any of claims 1 to 6 wherein said at least one overdamped correction cell and/or said at least one underdamped correction cell is implemented in an active analogical form.

8. Use of a system (300) according to any of claims 1 to 7 for detecting a leak by tracer gas.

[fig. 1]

[fig. 2]

[fig. 3]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2734053

- EP 1467200 A